# FASCICULE DE BREVET EUROPEEN

(11) **EP 2 267 465 B1**
(45) Date de publication et mention de la délivrance du brevet: **09.05.2012**
(21) Numéro de dépôt: 10354020.9
(22) Date de dépôt: 11.05.2010
(51) Int. Cl.: G01R 19/165

(54) **Dispositif et procédé d'indication de défauts électriques, ensemble et tableau électrique comportant un tel dispositif**
Vorrichtung und Verfahren zur Anzeige von elektrischen Fehlern, Einheit und elektrische Schalttafel, die diese Vorrichtung umfassen
Device and method for indicating electrical faults, assembly and electric board comprising such a device

(30) Priorité: 23.06.2009 FR 0903036
(43) Date de publication de la demande: 29.12.2010
(73) Titulaire: Schneider Electric Industries SAS, 92500 Rueil-Malmaison (FR)
(72) Inventeur: Tian, Simon, 38050 Grenoble Cedex 09 (FR); Zeller, Clément, 38050 Grenoble Cedex 09 (FR); Meunier-Carus, Jérôme, 38050 Grenoble Cedex 09 (FR)
(74) Mandataire: Tripodi, Paul

(56) Documents cités:
- EP-A1- 2 006 694
- WO-A1-2007/079990
- FR-A1- 2 659 744
- GB-A- 2 376 360

## Description

### DOMAINE TECHNIQUE

L'invention concerne un dispositif d'indication de défauts électriques comportant :
- des moyens de mesure de courant pour mesurer un courant de fuite, différentiel ou résiduel,
- des moyens de traitement comportant des moyens de détection de courant de défaut connectés audits moyens de mesure de courant et fournissant un premier signal de détection de défaut lorsque le courant mesuré dépasse un premier seuil prédéterminé, et
- des moyens de signalisation d'un défaut électrique connectés audits moyens de traitement.

L'invention concerne aussi un ensemble de protection différentielle comportant un appareil de coupure électrique avec des contacts principaux pouvant être déclenchés en ouverture lors d'un défaut électrique.

Un tableau de distribution électrique comportant une arrivée de ligne d'alimentation électrique et plusieurs départs de distribution électrique.

L'invention concerne aussi un procédé d'indication de défauts électriques.

### ETAT DE LA TECHNIQUE

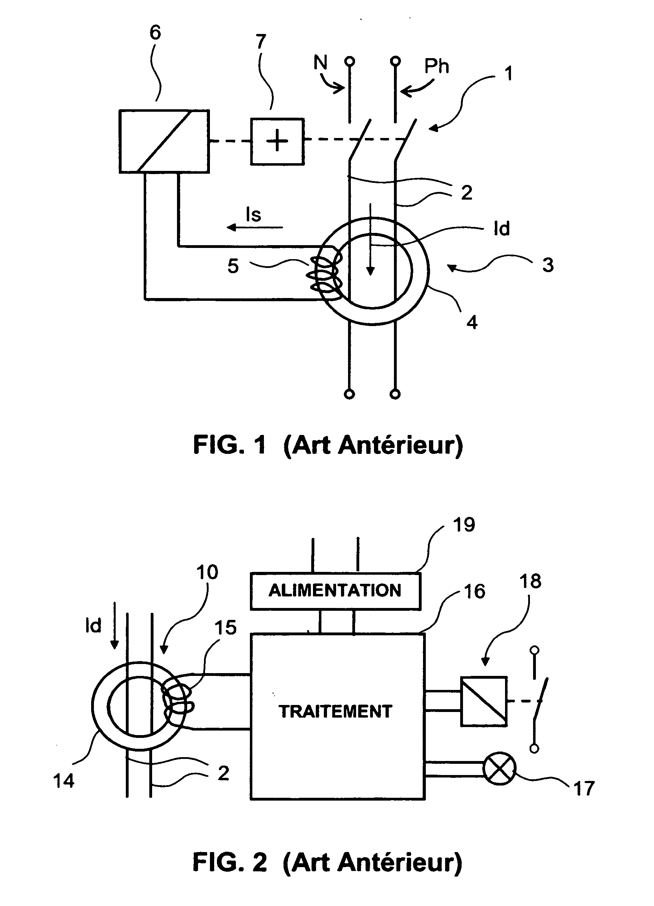

La figure 1 montre un exemple de schéma d'un appareil de protection différentielle. Cet appareil peut être un interrupteur différentiel ou un disjoncteur différentiel comportant des contacts principaux 1 pour interrompre un courant dans des conducteurs électriques. Un capteur 3 de courant différentiel Id permet de mesurer un courant différentiel ou résiduel circulant dans les conducteurs 2. Le capteur 3 comporte généralement un tore de mesure en circuit magnétique 4 entourant les conducteurs 2 et un enroulement secondaire 5 fournissant un courant secondaire Is pour commander un relais de déclenchement 6 lorsqu'un seuil de déclenchement est dépassé. Le relais 6 commande l'ouverture des contacts principaux 1 à travers un mécanisme de commande 7. Ces appareils de protection différentielle peuvent être utilisés en association avec des dispositifs d'indication de défauts électriques.

Un schéma d'un dispositif d'indication de défauts électriques est représenté sur la figure 2. Il peut être disposé en amont ou en aval d'un dispositif de protection différentiel, ou même être utilisé seul de manière isolée. Le dispositif comporte un capteur 10 de courant différentiel ou résiduel Id disposé autour de conducteurs 2 de courant électrique. Le capteur 10 est généralement constitué d'un tore 14 et d'un enroulement secondaire 15 pour fournir un courant secondaire Im de mesure représentatif du courant de différentiel Id à un circuit de traitement 16. Le circuit de traitement commande des moyens de signalisation locale ou à distance lorsque un seuil de courant de défaut est dépassé. Parmi ces moyens de signalisation, il peut y avoir un voyant 17 ou un relais 18. Un circuit d'alimentation 19 est connecté au circuit de traitement 16 pour alimenter et garder des informations de signalisation.

De manière connue, des dispositifs d'indication de défauts électriques sont utilisés pour la prévention d'un déclenchement d'un appareil de protection différentielle. Dans ce cas, le dispositif d'indication a un seuil de détection inférieur à un seuil de déclenchement. Lorsqu'un défaut est détecté le dispositif d'indication commande un dispositif d'alerte ou de visualisation locale ou à distance. Cette détection est généralement lente et filtrée pour éviter les alertes intempestives.

Dans d'autres systèmes connus, des dispositifs d'indication de défauts électriques sont utilisés pour localiser un défaut électrique après déclenchement. Ces dispositifs doivent avoir une alimentation auxiliaire même en cas de déclenchement ou d'ouverture de la ligne à surveiller. De plus, dans ce cas, la détection d'un courant de défaut électrique doit se faire de manière très rapide puisque il y a déclenchement et ouverture rapide du circuit électrique.

Des dispositifs connus sont divulgués dans les documents FR2659744, W02007/079990 et EP2006694.

Les dispositifs d'indication de défauts électriques connus ne permettent pas d'associer dans un même dispositif des fonctions de prévention d'un défaut électrique avant déclenchement et des fonctions de localisation après déclenchement. En effet, ces fonctions ont des caractéristiques très différentes et sont incompatibles dans la chaine de traitement.

### EXPOSE DE L'INVENTION

L'invention a pour but un dispositif et un procédé d'indication de défauts électriques permettant des fonctions de prévention et des fonctions de localisation, un ensemble de protection différentielle et un tableau électrique comportant un tel dispositif.

Dans un dispositif d'indication de défauts électriques selon l'invention lesdits moyens de traitement comportent :
- des moyens de détection d'une tension connectés à une entrée de contrôle de la présence de tension, et
- des moyens de traitement de la signalisation connectés audits moyens de détection d'une présence tension et audits moyens de détection de courants de défauts pour fournir audits moyens de signalisation un premier signal de signalisation lorsque ledit premier signal de détection de défaut est représentatif d'un dépassement de seuil et lorsque lesdits moyens de détection d'une tension ont détecté une perte de tension sur ladite entrée de contrôle de la présence de tension.

Avantageusement, lesdits moyens de détection de courant de défaut fournissent un second signal de détection de défaut lorsque le courant mesuré dépasse ledit premier seuil prédéterminé pendant une durée prédéterminée, et lesdits moyens de traitement de la signalisation fournissent audits moyens de signalisation un second signal de signalisation lorsque ledit second signal de détection est représentatif d'un dépassement de seuil pendant ladite durée prédéterminée.

Dans un mode de réalisation préférentiel, lesdits moyens de signalisation commandent :
- un premier type d'affichage représentatif de la localisation de défaut lorsque lesdits moyens de traitement de la signalisation fournissent ledit premier signal de signalisation, et
- un second type d'affichage représentatif de la prévention de défaut lorsque lesdits moyens de traitement de la signalisation fournissent ledit second signal de signalisation.

De préférence, le premier signal de signalisation et le second signal de signalisation sont appliqués à un même voyant et/ou à un même relais.

Avantageusement, lesdits moyens de signalisation comportent au moins un voyant bistable. De préférence, lesdits moyens de signalisation comportent au moins un voyant à cristaux liquides bistable.

Dans un mode de réalisation particulier, le dispositif comporte une première partie comportant lesdits moyens de traitement disposés dans un module pouvant être installé sur un support en forme de rail et une seconde partie comportant au moins lesdits moyens de mesure de courant et reliée à ladite première partie.

Un ensemble de protection différentielle selon l'invention comportant un appareil de coupure électrique avec des contacts principaux pouvant être déclenchés en ouverture lors d'un défaut électrique comporte un dispositif d'indication de défauts électriques tel que défini ci-dessus comportant une première partie disposée à coté dudit appareil de coupure électrique et une seconde partie supportant lesdits moyens de mesure de courant disposée en regard de bornes de sortie dudit appareil de coupure électrique.

Dans cet ensemble, ladite entrée de contrôle de la présence de tension est connectée de préférence en aval dudit appareil de coupure électrique.

Dans un tableau de distribution électrique selon l'invention comportant une arrivée de ligne d'alimentation électrique et plusieurs départs de distribution électrique, au moins un départ comporte un dispositif d'indication de défauts électriques tel que défini ci-dessus.

De préférence le tableau de distribution électrique comporte au moins un dispositif de protection différentielle en amont d'au moins un dispositif d'indication de défauts électriques.

Un procédé d'indication de défauts électriques selon l'invention comporte :
- la mesure de courant de défaut différentiel ou résiduel,
- la comparaison dudit courant de défaut à un premier seuil de détection pour détecter un dépassement de seuil,
- la détection d'un dépassement dudit premier seuil pendant une durée prédéterminée,
- la détection de la perte de présence de tension électrique sur une entrée de contrôle de la présence de tension,
- la signalisation d'un défaut électrique de localisation lorsqu'un dépassement dudit premier seuil est détecté et que la détection de présence tension détecte une perte de tension.

Avantageusement, le procédé d'indication comporte aussi la signalisation d'un défaut électrique de prévention lorsqu'un dépassement dudit premier seuil pendant une durée prédéterminée est effectué.

De préférence, le procédé d'indication comporte aussi la mémorisation de la signalisation d'un défaut électrique de localisation, et l'acquittement de la signalisation d'un défaut électrique de localisation.

### BREVE DESCRIPTION DES DESSINS

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :
- la figure 1 représente un dispositif de protection différentielle connu ;
- la figure 2 représente un dispositif d'indication de défauts électriques connu ;
- la figure 3 représente un schéma bloc d'un dispositif d'indication de défauts électriques selon un mode de réalisation de l'invention ;
- les figures 4 et 5 représentent des schémas de modules d'un dispositif d'indication de défauts électriques selon un mode de réalisation de l'invention ;
- la figure 6 représente un organigramme d'un procédé d'indication de défauts électriques selon un mode de réalisation de l'invention ;
- les figures 7, 8 et 9 représentent des chronogrammes de fonctionnement de dispositifs ou de procédés d'indication de défauts électriques selon des modes de réalisation de l'invention ;
- la figure 10 représente un ensemble comportant un dispositif de protection différentielle et un dispositif d'indication de défauts électriques selon un mode de réalisation de l'invention ;
- la figure 11 représente un schéma d'un tableau électrique comportant des dispositifs d'indication de défauts électriques selon un mode de réalisation de l'invention disposés sur des départs protégés ;
- la figure 12 représente un schéma d'un tableau électrique comportant un dispositif de coupure à protection différentielle et des dispositifs d'indication de défauts électriques selon un mode de réalisation de l'invention disposés sur des départs en dérivation ;
- la figure 13 représente un dispositif d'indication de défauts électriques selon un premier mode de réalisation de l'invention à passage de câbles électriques disposé à coté d'un appareil électrique ;
- la figure 14 représente un dispositif d'indication de défauts électriques selon un second mode de réalisation de l'invention connexion électrique en aval d'un appareil électrique ;
- la figure 15 représente un ensemble de comportant un dispositif de protection différentielle et un dispositif d'indication de défauts électriques disposés dans un même boîtier ;
- la figure 16 représente un dispositif d'indication de défauts électriques selon un troisième mode de réalisation de l'invention comportant une liaison amont-aval des conducteurs de courant ;
- figure 17 représente un dispositif d'indication de défauts électriques selon un quatrième mode de réalisation de l'invention comportant un transformateur de mesure de courant de défaut déporté ; et
- les figures 18 et 19 représentent un schéma et un chronogramme de la commande d'un voyant bistable utilisé dans un dispositif selon un mode de réalisation de l'invention.

### DESCRIPTION DETAILLEE DE MODES DE REALISATION PREFERES

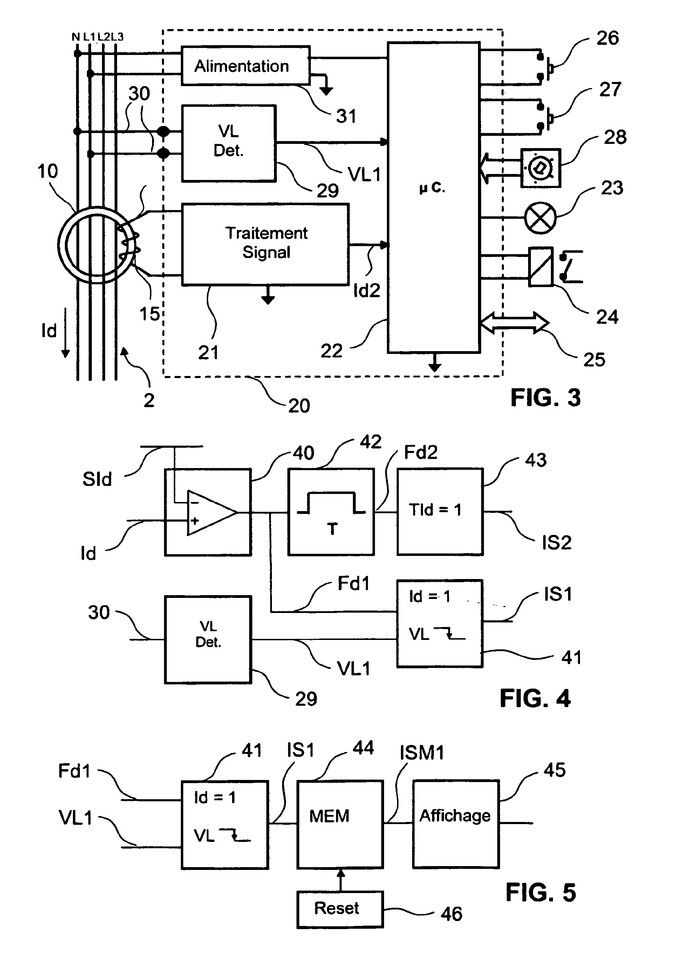

Un dispositif d'indication de défauts électriques selon un mode de réalisation préféré est représenté sur la figure 3 par un schéma bloc. Ce dispositif comporte un capteur 10 de mesure de courant pour mesurer un courant de fuite, différentiel ou résiduel. Le capteur 10 est généralement constitué d'un transformateur en forme de tore disposé autour de conducteurs 2 de courant électrique et d'un enroulement secondaire 15 pour fournir un signal Id1 représentatif d'un courant différentiel Id à un circuit de traitement 20.

Le circuit de traitement 20 comporte un module 21 de traitement de signal pour conditionner le signal de courant secondaire Id1 en signal Id2 pouvant être traité pas des circuits électroniques analogiques ou numériques. Le module 22 peut comporter des fonctions de réglage de calibres ou de seuils. Le circuit de traitement 20 comporte aussi un circuit de traitement global 22 pour recevoir le signal Id2 représentatif d'un courant différentiel et pour fournir un premier signal de détection de défaut Fd1 lorsque le courant mesuré dépasse un premier seuil prédéterminé Sld. Généralement, le seuil Sld est inférieur à des seuils de déclenchement de dispositifs de protection différentielle.

Le dispositif d'indication de défauts électriques comporte aussi des moyens de signalisation d'un défaut électrique connectés au circuit 22. Les moyens de signalisation peuvent être notamment un voyant 23, un relais 24 ou une liaison par bus de communication 25. Dans le mode de réalisation de la figure 3, des organes de commandes sont connectés au circuit de traitement 20. Parmi ces organes de commande, un interrupteur 26 commande le test du dispositif d'indication, un interrupteur 27 commande l'acquittement ou la remise à zéro de la signalisation dans les cas de mémorisation de défaut, et un commutateur 28 est utilisé pour les réglages de seuils de la signalisation. Un circuit d'alimentation 31 alimente les circuits du dispositif de traitement.

Dans un mode de réalisation préférentiel de l'invention, le circuit de traitement 20 comporte un circuit 29 de détection d'une tension de ligne connecté à une entrée 30 de contrôle de la présence de tension et pour fournir un signal de présence tension VL1. Sur la figure 3 le circuit de traitement 22 est connecté au circuit 29 de détection d'une présence tension et traite le courant de défaut Id2 pour fournir aux moyens de signalisation un premier signal de signalisation IS1 lorsque ledit premier signal de détection est représentatif d'un dépassement de seuil et lorsque le circuit 29 a détecté une perte de tension sur ladite entrée 30 de contrôle de la présence de tension. Le dépassement de seuil peut être en même temps ou avant la perte de tension.

De préférence, les entrées de tension 30 peuvent être raccordées en amont ou en aval de la mesure de courant du dispositif d'indication de défaut. Ces entrées 30 peuvent aussi être connectées à des points plus éloignés du réseau de distribution électrique.

La figure 4 représente un schéma de modules d'un dispositif d'indication de défauts électriques selon un mode de réalisation de l'invention. Un comparateur 40 compare le signal représentatif d'un courant différentiel à un seuil Sld. Si le seuil est dépassé, un premier signal de défaut différentiel Fd1 est fourni à un premier module de traitement de signalisation 41. Le circuit 29 de détection d'une tension de ligne fournit aussi un signal VL1 représentatif de la présence de tension de ligne au module 41. Ainsi, le module 41 traite les signaux Fd1 et VL1, et fournit le premier signal de signalisation IS1 lorsque le signal VL1 signale une perte de la tension de ligne pendant la présence d'un signal de détection de défaut Fd1. Le signal Fd1 peut être mémorisé quelques instants pour garantir la détection d'un défaut précédant immédiatement la perte de tension. La figure 4 montre aussi un module 42 de temporisation recevant le premier signal Fd1 de défaut différentiel et fournissant un second signal de défaut différentiel Fd2 lorsque le premier signal est présent pendant un temps T prédéterminé. Ainsi, un second signal de détection de courant de défaut est fournit lorsque le courant mesuré dépasse ledit premier seuil prédéterminé pendant une durée T prédéterminée. Le second signal de signalisation est alors représentatif d'un dépassement de seuil pendant une durée prédéterminée. Un second module de traitement de signalisation 43 reçoit le second signal Fd2 et fournit un second signal de signalisation IS2 pour signaler le dépassement de seuil pendant une durée T. Le module 43 peut effectuer une mémorisation de la signalisation et être ensuite acquitté par une commande spéciale.

La figure 5 montre une chaine d'affichage du premier signal de signalisation. Un module 44 de mémorisation reçoit le signal IS1 lorsqu'il y a perte de tension pendant ou juste après un défaut différentiel et fournit un signal ISM1 de signalisation mémorisé à un organe d'affichage ou de signalisation à distance. Un module ou un organe 46 effectue sur commande une remise à zéro ou l'acquittement du module de mémorisation 44.

De préférence, un premier type d'affichage est représentatif de la localisation de défaut lorsque le module 41 fournit ledit premier signal de signalisation IS1, et un second type d'affichage est représentatif de la prévention de défaut lorsque le module 43 fournit ledit second signal de signalisation IS2. Dans un autre mode de réalisation, le premier signal de signalisation IS1 et le second signal de signalisation IS2 peuvent être appliqués à un même voyant et/ou à un même relais. Dans ce cas, le signal IS1 de prévention est actif pendant un fonctionnement normal et le signal IS2 de localisation reste actif après déclenchement et ouverture sur défaut d'un circuit électrique par un interrupteur ou un disjoncteur.

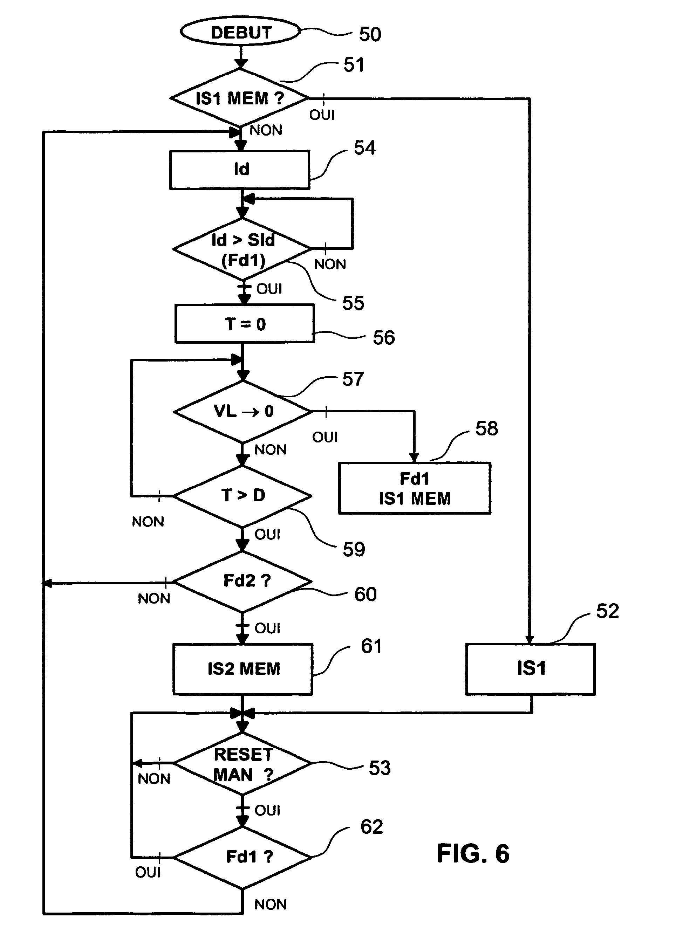

La figure 6 représente un organigramme d'un procédé d'indication de défauts électriques selon un mode de réalisation de l'invention. Après l"initialisation du procédé à une étape 50, une étape 51 vérifie si un signal IS1 de signalisation pour localisation de défaut est mémorisé. Si le signal est mémorisé, une étape 52 commande l'affichage ou confirme l'affichage du signal IS1. Ce signal peut être effacé à une étape 53 par un acquittement manuel par exemple. En fonctionnement normal, une étape 54 effectue la mesure de courant de défaut différentiel ou résiduel. A une étape 55, il y a la comparaison dudit courant de défaut à un premier seuil de détection pour détecter un dépassement de seuil. Une étape 56 initialise un compteur de temps pour la détection d'un dépassement dudit premier seuil pendant une durée prédéterminée. A une étape 57, la détection de la perte de présence de tension électrique sur une entrée de contrôle de la présence de tension est effectuée. Si une perte de présence tension est détectée, une étape 58 signale un défaut électrique de localisation puisque un dépassement dudit premier seuil est réalisé et que la détection de présence tension détecte une perte de tension. L'étape 58 permet aussi la signalisation de la localisation d'un défaut électrique. L'acquittement de la signalisation de la localisation d'un défaut électrique est effectué à l'étape 53.

Si une perte de tension n'est pas détectée, une étape 59 contrôle la fin de la temporisation. Si le courant de défaut est toujours présent, une étape 60 fournit un second signal de défaut Fd2 pour effectuer la signalisation de prévention d'un défaut électrique puisque le premier seuil est dépassé pendant une durée prédéterminée. Dans certains cas, une étape 62 contrôle la présence d'un défaut avant la réinitialisation.

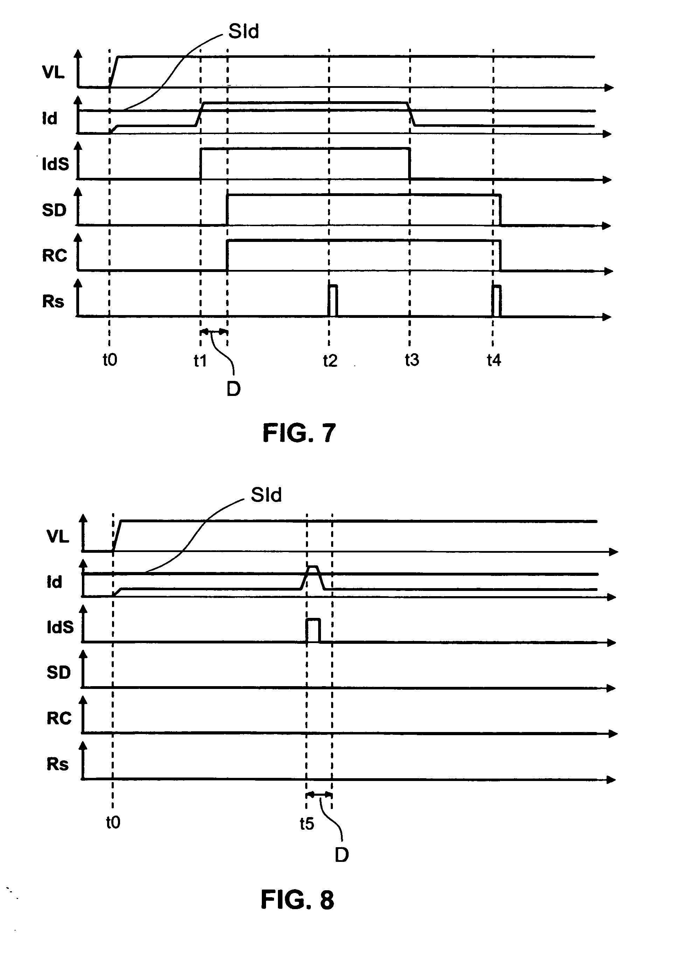

Les figures 7, 8 et 9 représentent des chronogrammes de fonctionnement de dispositifs ou de procédés d'indication de défauts électriques selon des modes de réalisation de l'invention. La figure 7 présente le cas où un défaut différentiel long est détecté sans déclenchement. La tension représentée par le signal VL est présente depuis le début à l'instant t0. A un instant t1, le courant de défaut différentiel Id dépasse un seuil Sld. Ce défaut est signalé immédiatement sur une sortie IdS du dispositif. Puisque le défaut est toujours présent au bout d'un délai D de durée prédéterminée, un signal de visualisation locale SD commande des moyens de visualisation et un signal RC commande un relais de signalisation. Dans ce cas, le signal de visualisation est représentatif de la prévention d'un défaut. A un instant t2, une commande d'acquittement ou de remise à zéro Rs n'est pas prise en compte puisque le défaut est encore présent. A un instant t3, le courant de défaut dévient inférieur au seuil Sld, ce changement est signalé immédiatement sur la sortie Ids. Les signaux SD et RC étant mémorisés, ils continuent à signaler la prévention de défaut jusqu'à un instant t4 de commande d'acquittement.

La figure 8 présente le cas où un défaut différentiel court est détecté. La tension représentée par le signal VL est présente depuis le début à l'instant t0. A un instant t5, le courant de défaut différentiel Id dépasse un seuil Sld pendant une courte durée. Ce dépassement est signalé immédiatement sur une sortie Ids du dispositif. Puisque ce court dépassement est de durée inférieure à la durée D prédéterminée, les signaux de signalisation SD et RC ne sont pas activés.

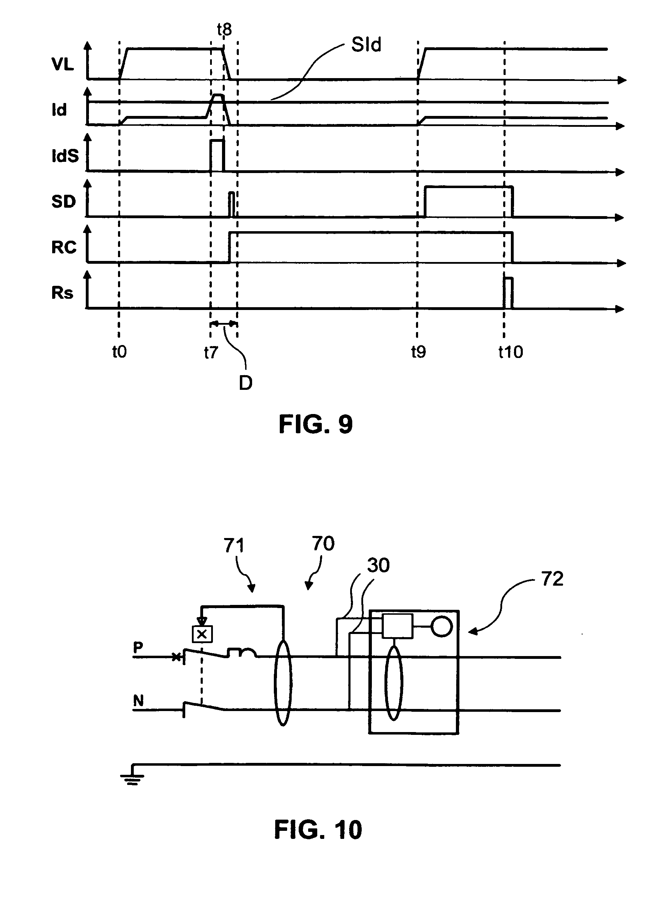

La figure 9 présente le cas où un défaut différentiel est détecté et un déclenchement ce produit. La tension représentée par le signal VL est présente depuis le début à l'instant t0. A un instant t7, le courant de défaut différentiel Id dépasse un seuil Sld. Ce dépassement est signalé immédiatement sur une sortie Ids du dispositif. A un instant t8, la tension VL n'est plus présente et le courant de défaut Id s'annule. Le délai entre les instants t8 et t7 et inférieur a la période de durée prédéterminée D. Cette situation est représentative d'un défaut avec déclenchement. Il est alors nécessaire de localiser le défaut après déclenchement. Un signal de visualisation SD est fournit à des afficheurs locaux et un signal RC mémorisé commande un relais. Dans ce cas, les signaux de visualisation sont représentatifs d'un signal de localisation de défaut. Si la tension VL sert aussi à l'alimentation du dispositif, le signal SD peut être interrompu alors que le signal du relais RC peut rester actif. A un instant t9, la tension VL est de nouveau présente et le courant de défaut Id est inférieur au seuil. Les signaux SD et RC étant mémorisés, la signalisation de localisation de défaut se poursuit. A un instant t10 une commande d'acquittement réinitialise le dispositif en effaçant la mémorisation des signaux. Le dépassement du seuil par le courant Id peut être mémorisé quelques instants pour garantir la détection d'un défaut précédant la perte de tension.

La figure 10 représente un ensemble 70 comportant un dispositif 71 de protection différentielle et un dispositif 72 d'indication de défauts électriques selon un mode de réalisation de l'invention. Le dispositif de protection différentielle comporte des contacts principaux 1 pouvant être déclenchés en ouverture lors d'un défaut électrique. Le dispositif d'indication de défauts électriques est tel que défini dans des modes de réalisation décrits ci-dessus. Dans cette figure, une entrée de contrôle de la présence de tension est connectée en aval dudit dispositif de protection différentielle.

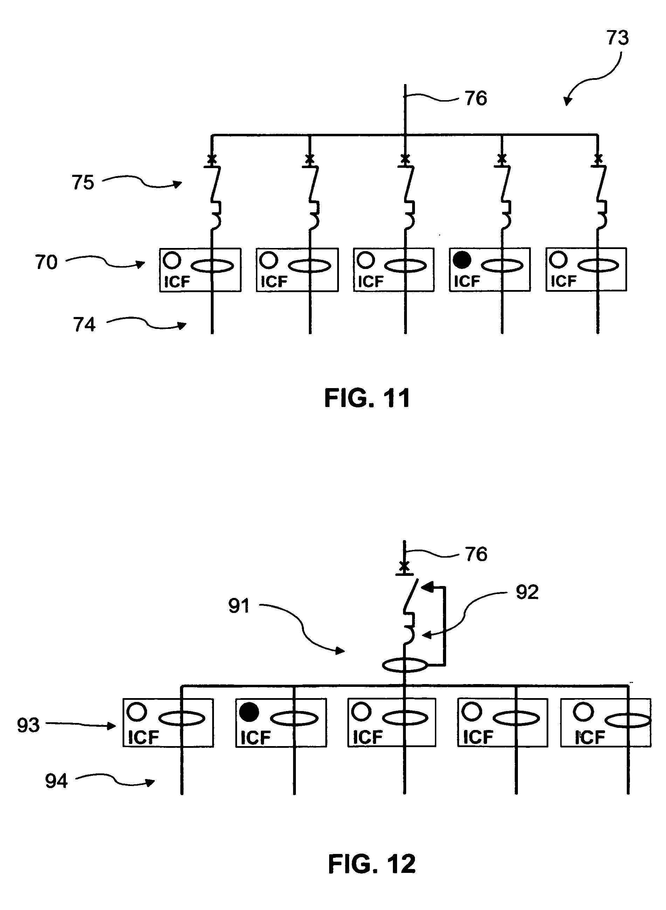

La figure 11 représente un schéma d'un tableau électrique 73 comportant des dispositifs 70 d'indication de défauts électriques selon un mode de réalisation de l'invention disposés sur des départs protégés par des disjoncteurs 75. Une ligne d'arrivée d'alimentation électrique 76 alimente plusieurs départs protégés 74 de distribution électrique. Un ou plusieurs départs comportent un dispositif d'indication de défauts électriques 70 disposés en aval des disjoncteurs 75.

La figure 12 représente un schéma d'un tableau électrique comportant un dispositif 92 de coupure à protection différentielle en amont de plusieurs dispositifs 93 d'indication de défauts électriques disposés sur des départs 94 en dérivation.

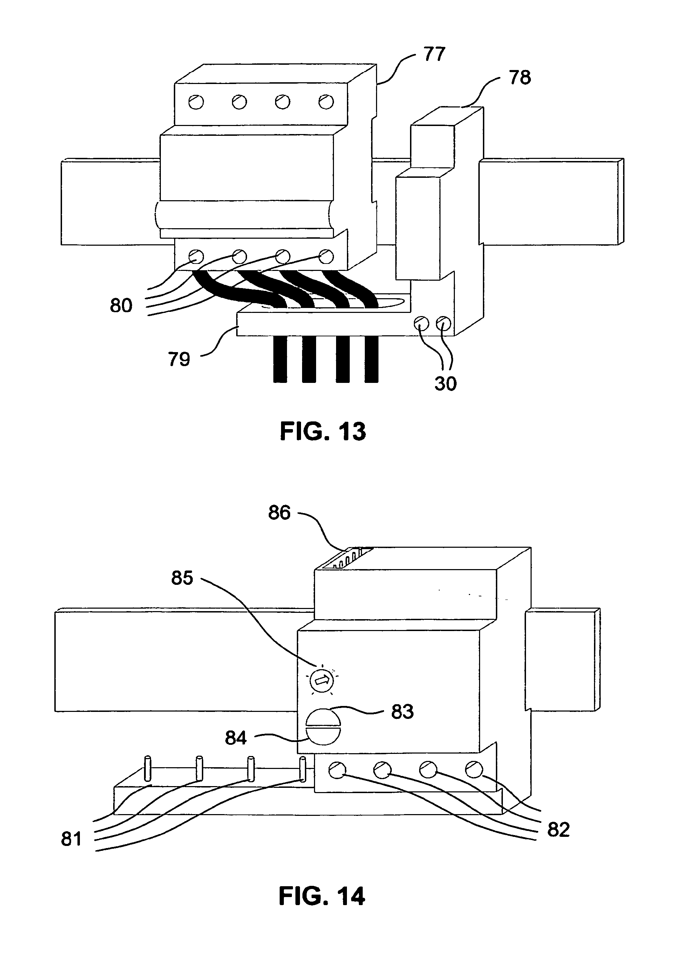

La figure 13 représente un dispositif d'indication de défauts électriques selon un premier mode de réalisation de l'invention à passage de câbles électriques disposé à coté d'un appareil électrique 77. Le dispositif d'indication comporte une première partie 78 disposée à coté de l'appareil électrique 77 et une seconde partie 79 supportant le capteur de courant différentiel disposée en regard de bornes de sortie dudit appareil électrique. Des bornes d'entrée 30 sont disposées sur la première partie 78. L'appareil électrique est de préférence un interrupteur ou un disjoncteur avec ou sans protection différentielle.

La figure 14 représente un dispositif d'indication de défauts électriques selon un second mode de réalisation de l'invention avec des connexions électriques 81 à connecter en aval d'un appareil électrique. Le capteur de courant étant à l'intérieur de l'appareil, des bornes de sorties 82 sont disposées dans le boitier du dispositif. Ce boitier comporte des voyants de signalisation différenciée 83 et 84, un organe de réglage 85, et des connecteurs auxiliaires 86. Les connecteurs 86 peuvent recevoir des bus de communication, des sorties de relais et/ou l'entrée de présence tension. Dans ce mode de réalisation, l'entrée de présence tension peut aussi être avantageusement récupérée sur les connexions 81 en aval de l'appareil électrique. Ainsi, la localisation de défaut est signalée avec l'appareil électrique associé au départ en défaut.

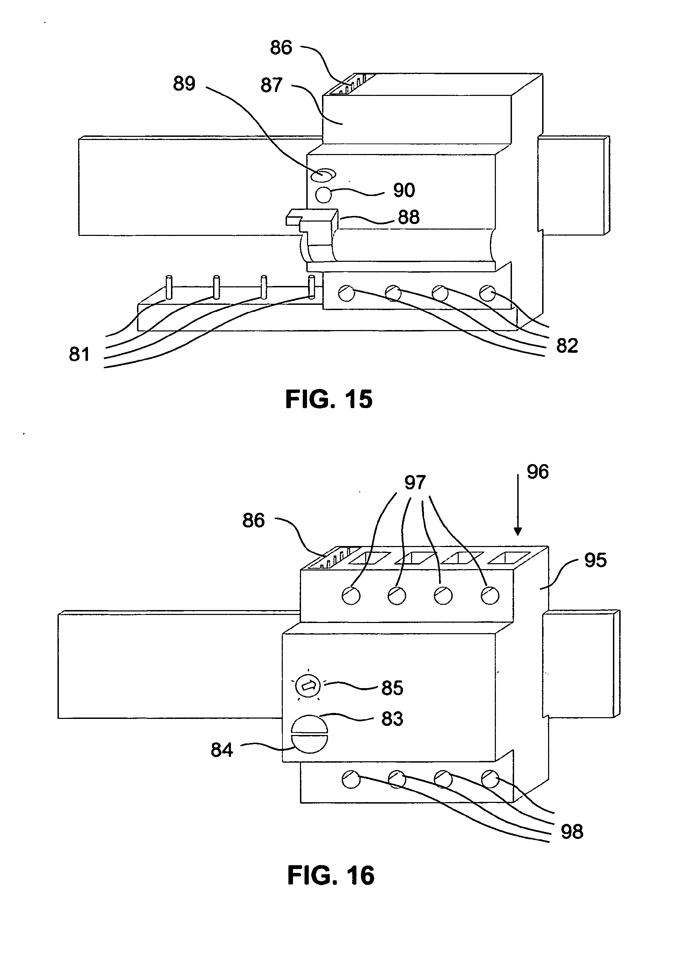

La figure 15 représente un ensemble comportant un dispositif de protection différentielle et un dispositif d'indication de défauts électriques disposés dans un même boîtier 87. En plus des éléments du dispositif d'indication de défauts électriques, le boitier comporte une liaison mécanique 88 entre le dispositif de protection différentielle et un appareil de coupure électrique, et bouton de test 89 pour tester la fonction de protection différentielle. Un voyant 90 est utilisé pour visualiser plusieurs fonctions du courant de défaut différentiel.

La figure 16 représente un dispositif 95 d'indication de défauts électriques selon un autre mode de réalisation de l'invention comportant une liaison amont-aval des conducteurs de courant 2. La liaison amont-aval peut se faire par des traversées directes 96 de câbles ou par des bornes de connexion en amont 97 et en aval 98.

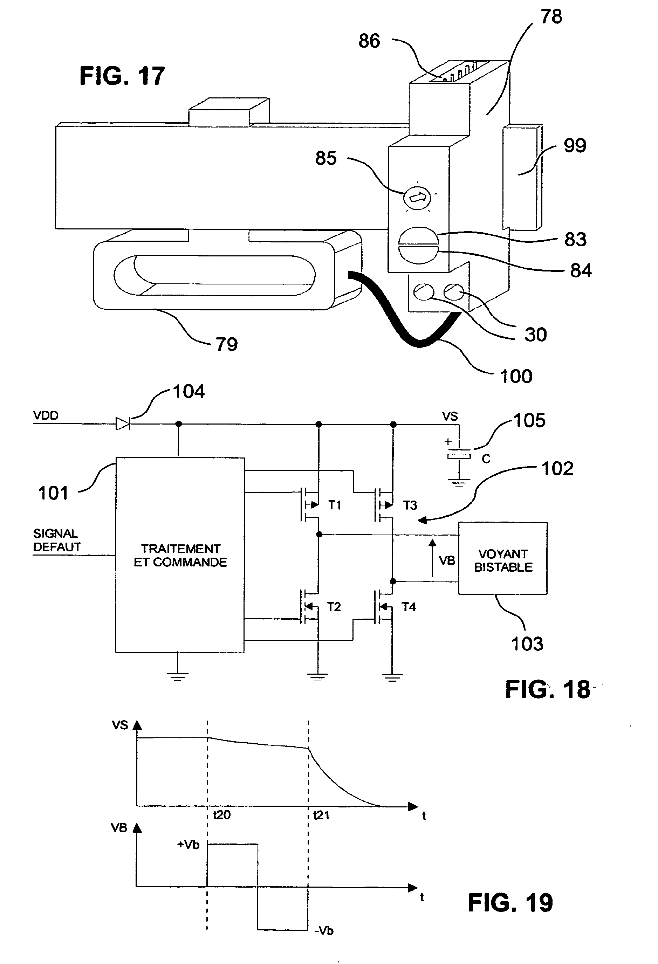

La figure 17 représente un dispositif d'indication de défauts électriques selon un autre mode de réalisation de l'invention comportant un transformateur de mesure de courant de défaut déporté. Ainsi le dispositif comporte une première partie 78 comportant le circuit de traitement 20 disposé dans un module pouvant être installé sur un support 99 en forme de rail et une seconde partie 79 comportant au moins un capteur de mesure de courant 10 reliée à la première partie par une liaison électrique 100.

Les moyens de signalisation peuvent être différenciés entre la signalisation pour prévention 83 et la signalisation de localisation de défaut 84 après perte de tension ou déclenchement. Les voyants utilisés peuvent être de préférence du type bistable gardant leur état après commande sans être alimentés en énergie électrique. Avantageusement, les voyants bistables sont des voyants ou des afficheurs à cristaux liquides bistable changeant de couleur en fonction de la polarité de la tension de commande ou d'alimentation. Par exemple ces voyants bistables peuvent être du type à cristaux liquides cholestériques.

Les figures 18 et 19 représentent un schéma et un chronogramme de la commande d'un voyant bistable utilisé dans un dispositif selon un mode de réalisation de l'invention. Un circuit de traitement de l'affichage 101 commande un inverseur de tension 102 pour alimenter un afficheur bistable 103 selon une première polarité de tension ou une seconde polarité inversée. Une diode 104 et un condensateur 105 permettent de stoker suffisamment d'énergie électrique pour alimenter par une tension VS la commande de l'afficheur après la disparition d'une tension électrique d'alimentation VDD. Sur le chronogramme, à l'instant t20 la tension VS et de l'ordre de la tension VDD. Une commande de visualisation alimente le voyant bistable soit avec une première polarité +VB soit -VB. Puis à l'instant t21, le voyant reste dans sa couleur d'affichage correspondant à la commande.

Les types d'affichages pour la prévention de défaut ou pour la localisation de défaut peuvent prendre plusieurs formes. Par exemples, avec deux voyants distincts. Dans un autre mode de réalisation, un même voyant peut être commandé de manière clignotante pour afficher la prévention de défaut ou de manière fixe et mémorisée pour afficher la localisation de défaut. Un changement de la couleur d'affichage d'un même voyant peut aussi être représentatif de la prévention ou de la localisation de défaut.

Le courant différentiel décrit ci-dessus correspond également à un courant résiduel, a un courant de fuite, à un courant de défaut terre ou à un courant homopolaire. Les dispositifs selon l'invention s'appliquent aussi bien aux distributions électriques bipolaires, tripolaires ou tétra-polaires.

Dans d'autres modes de réalisation, un dispositif peut avoir plusieurs circuits traitements reliés à plusieurs capteurs de courant. Dans ce cas, une entrée de tension commune peut servir à localiser des défauts de plusieurs départs.

## Revendications

1. Dispositif d'indication de défauts électriques comportant
- des moyens (10) de mesure de courant pour mesurer un courant de fuite, différentiel ou résiduel,
- des moyens (16) de traitement comportant des moyens (21) de détection de courant de défaut connectés audits moyens de mesure de courant et fournissant un premier signal (Fd1) de détection de défaut lorsque le courant mesuré dépasse un premier seuil (Sld) prédéterminé, et
- des moyens (17, 18) de signalisation d'un défaut électrique connectés audits moyens de traitement,
dispositif **caractérisé en ce que** lesdits moyens de traitement comportent :
- des moyens (29) de détection d'une tension connectés à une entrée (30) de contrôle de la présence de tension, et
- des moyens (22) de traitement de la signalisation connectés audits moyens (29) de détection d'une présence tension et audits moyens (40) de détection de courants de défauts pour fournir audits moyens (23, 24, 25) de signalisation un premier signal (IS1) de signalisation lorsque ledit premier signal de détection de défaut (Fd1) est représentatif d'un dépassement de seuil et lorsque lesdits moyens (29) de détection d'une tension ont détecté une perte de tension sur ladite entrée de contrôle de la présence de tension.

2. Dispositif selon la revendication 1 **caractérisé en ce que** lesdits moyens (40, 42) de détection de courant de défaut fournissent un second signal (Fd2) de détection de défaut lorsque le courant mesuré dépasse ledit premier seuil prédéterminé pendant une durée prédéterminée (T), et lesdits moyens (22, 43) de traitement de la signalisation fournissent audits moyens (23, 24, 25) de signalisation un second signal (IS2) de signalisation lorsque ledit second signal (Fd2) de détection est représentatif d'un dépassement de seuil pendant ladite durée prédéterminée (T).

3. Dispositif selon la revendication 2 **caractérisé en ce que** lesdits moyens de signalisation commandent un premier type d'affichage représentatif de la localisation de défaut lorsque lesdits moyens de traitement de la signalisation fournissent ledit premier signal (IS1) de signalisation, et un second type d'affichage représentatif de la prévention de défaut lorsque lesdits moyens de traitement de la signalisation fournissent ledit second signal (IS2) de signalisation.

4. Dispositif selon l'une quelconque des revendications 1 à 3 **caractérisé en ce que** le premier signal (IS1) de signalisation et le second signal (IS2) de signalisation sont appliqués à un même voyant (23, 90, 103) et/ou à un même relais (24).

5. Dispositif selon l'une quelconque des revendications 1 à 4 **caractérisé en ce que** lesdits moyens de signalisation comportent au moins un voyant bistable (103).

6. Dispositif selon l'une quelconque des revendications 1 à 4 **caractérisé en ce que** lesdits moyens de signalisation comportent au moins un voyant (103) à cristaux liquides bistable.

7. Dispositif selon l'une quelconque des revendications 1 à 6 **caractérisé en ce qu'**il comporte une première partie (78) comportant lesdits moyens de traitement disposés dans un module pouvant être installé sur un support en forme de rail et une seconde partie (79) comportant au moins lesdits moyens (30) de mesure de courant et reliée à ladite première partie.

8. Ensemble de protection différentielle comportant un appareil (71, 77) de coupure électrique avec des contacts principaux (1) pouvant être déclenchés en ouverture lors d'un défaut électrique **caractérisé en ce qu'**il comporte un dispositif (72, 78, 79) d'indication de défauts électriques selon l'une quelconque des revendications 1 à 7 comportant une première partie (78) disposée à coté dudit appareil de coupure électrique et une seconde partie (79) supportant lesdits moyens (10) de mesure de courant disposée en regard de bornes (80) de sortie dudit appareil de coupure électrique.

9. Ensemble de protection différentielle selon la revendication 8 **caractérisé en ce que** ladite entrée (30) de contrôle de la présence de tension est connectée en aval dudit appareil (71, 77) de coupure électrique.

10. Tableau de distribution électrique comportant une arrivée (76) de ligne d'alimentation électrique et plusieurs départs (74, 94) de distribution électrique **caractérisé en ce qu'**au moins un départ comporte un dispositif (70, 93) d'indication de défauts électriques selon l'une des revendications 1 à 7.

11. Tableau de distribution électrique selon la revendication 10 **caractérisé en ce qu'**il comporte au moins un dispositif (92) de protection différentielle en amont d'au moins un dispositif (93) d'indication de défauts électriques.

12. Procédé d'indication de défauts électriques **caractérisé en ce qu'**il comporte :
- la mesure (54) de courant de défaut différentiel ou résiduel,
- la comparaison (55) dudit courant de défaut à un premier seuil de détection pour détecter un dépassement de seuil,
- la détection (56, 59) d'un dépassement dudit premier seuil pendant une durée (T) prédéterminée,
- la détection (57) de la perte de présence de tension électrique sur une entrée de contrôle de la présence de tension,
- la signalisation (58) d'un défaut électrique de localisation lorsqu'un dépassement (55) dudit premier seuil est détecté et que la détection (57) de présence tension détecte une perte de tension.

13. Procédé d'indication selon la revendication 10 **caractérisé en ce qu'**il comporte la signalisation (60, 61) d'un défaut électrique de prévention lorsqu'un dépassement dudit premier seuil pendant une durée (T) prédéterminée est effectué.

14. Procédé d'indication selon l'une des revendications 10 ou 11 **caractérisé en ce qu'**il comporte la mémorisation (58) de la signalisation d'un défaut électrique de localisation, et l'acquittement (53) de la signalisation d'un défaut électrique de localisation.

## Claims

1. A device for annunciating electric faults comprising:
- current measuring means (10) for measuring a leakage, differential or residual current,
- processing means (16) comprising fault current detection means (21) connected to said current measuring means and providing a first fault detection signal (Fd1) when the measured current exceeds a predefined first threshold (Sld), and
- means (17, 18) for annunciating an electric fault connected to said processing means,
a device **characterized in that** said processing means comprise:
- voltage detection means (29) connected to a voltage presence monitoring input (30), and
- annunciation processing means (22) connected to said voltage detection means (29) and to said fault current detection means (40) to provide said annunciation means (23, 24, 25) with a first annunciation signal (IS1) when said first fault detection signal (Fd1) is representative of a threshold overshoot and when said voltage detection means (29) have detected a voltage outage on said voltage presence monitoring input.

2. The device according to claim 1 **characterized in that** said fault current detection means (40, 42) provide a second fault detection signal (Fd2) when the measured current exceeds said predefined first threshold for a predefined time (T), and said annunciation processing means (22, 43) provide said annunciation means (23, 24, 25) with a second annunciation signal (IS2) when said second detection signal (Fd2) is representative of a threshold overshoot during said predefined time (T).

3. The device according to claim 2 **characterized in that** said annunciation means command a first type of display representative of fault location when said annunciation processing means provide said first annunciation signal (IS1), and a second type of display representative of fault prevention when said annunciation processing means provide said second annunciation signal (IS2).

4. The device according to any one of claims 1 to 3 **characterized in that** the first annunciation signal (IS1) and the second annunciation signal (IS2) are applied to one and the same indicator (23, 90, 103) and/or to one and the same relay (24).

5. The device according to any one of claims 1 to 4 **characterized in that** said annunciation means comprise at least one bistable indicator (103).

6. The device according to any one of claims 1 to 4 **characterized in that** said annunciation means comprise at least one bistable liquid crystal display indicator (103).

7. The device according to any one of claims 1 to 6 **characterized in that** it comprises a first part (78) comprising said processing means arranged in a module able to be fitted on a support in the form of a rail and a second part (79) comprising at least said current measuring means (30) and connected to said first part.

8. A differential protection unit comprising an electric switchgear apparatus (71, 77) with main contacts (1) able to be tripped to open when an electric fault occurs **characterized in that** it comprises an electric fault annunciation device (72, 78, 79) according to any one of claims 1 to 7 comprising a first part (78) arranged next to said electric switchgear apparatus and a second part (79) supporting said current measuring means (10) arranged facing output terminals (80) of said electric switchgear apparatus.

9. The differential protection unit according to claim 8 **characterized in that** said voltage presence monitoring input (30) is connected load-side from said electric switchgear apparatus (71, 77).

10. An electric distribution panel comprising an electric power supply line incomer (76) and several electric distribution feeders (74, 94) **characterized in that** at least one feeder comprises an electric fault annunciation device (70, 93) according to one of claims 1 to 7.

11. The electric distribution panel according to claim 10 **characterized in that** it comprises at least one differential protection device (92) line-side from at least one electric fault annunciation device (93).

12. The electric fault annunciation method **characterized in that** it comprises:
- measurement (54) of differential or residual fault current,
- comparison (55) of said fault current with a first detection threshold to detect a threshold overshoot,
- detection (56, 59) of an overshoot of said first threshold during a predefined time (T),
- detection (57) of an electric voltage outage on a voltage presence monitoring input,
- annunciation (58) of electric fault location when an overshoot (55) of said first threshold is detected and the voltage presence detection (57) detects a voltage outage.

13. An annunciation method according to claim 10 **characterized in that** it comprises annunciation (60, 61) of electric fault prevention when an overshoot of said first threshold during a predefined time (T) occurs.

14. The annunciation method according to one of claims 10 or 11 **characterized in that** it comprises storing (58) of electric fault location annunciation and acknowledgement (53) of electric fault location annunciation.

## Patentansprüche

1. Einrichtung zur Anzeige von elektrischen Fehlern mit
- Strommessmitteln (10) zur Messung eines Leck-, Differenz- oder Nullstroms,
- Verarbeitungsmitteln (16) mit Fehlerstrom-Detektionsmitteln (21), die an die genannten Strommessmittel angeschlossen sind und ein erstes Fehlerdetektionssignal (Fd1) liefern, wenn der gemessene Strom einen festgelegten ersten Schwellwert (Sld) überschreitet, und
- an die genannten Verarbeitungsmittel angeschlossenen Anzeigemitteln (17, 18) zur Anzeige eines elektrischen Fehlers,
welche Einrichtung **dadurch gekennzeichnet ist, dass** die genannten Verarbeitungsmittel
- an einen Spannungsnachweis-Prüfeingang (30) angeschlossene Spannungsdetektionsmittel (29) sowie
- an die genannten Spannungsdetektionsmittel (29) und die genannten Fehlerstrom-Detektionsmittel (40) angeschlossene Anzeigeverarbeitungsmittel (22) umfasst, die dazu dienen, ein erstes Anzeigesignal (IS1) an die genannten Anzeigemittel (23, 24, 25) zu liefern, wenn das genannte erste Fehlerdetektionssignal (Fd1) eine Schwellwertüberschreitung abbildet und wenn die genannten Spannungsdetektionsmittel (29) einen Spannungsverlust am genannten Spannungsnachweis-Prüfeingang erkannt haben.

2. Einrichtung nach Anspruch 1, **dadurch gekennzeichnet, dass** die genannten Fehlerstrom-Detektionsmittel (40, 42) ein zweites Fehlerdetektionssignal (Fd2) liefern, wenn der gemessene Strom während einer festgelegten Zeitdauer (T) über dem genannten ersten Schwellwert liegt, und dass die genannten Anzeigeverarbeitungsmittel (22, 43) ein zweites Anzeigesignal (IS2) an die genannten Anzeigemittel (23, 24, 25) liefern, wenn das zweite Detektionssignal (Fd2) eine Schwellwertüberschreitung während der genannten festgelegten Zeitdauer (T) abbildet.

3. Einrichtung nach Anspruch 2, **dadurch gekennzeichnet, dass** die genannten Anzeigemittel eine die Fehlerlokalisierung abbildende erste Art der Anzeige ansteuern, wenn die genannten Anzeigeverarbeitungsmittel das genannte erste Anzeigesignal (IS1) liefern, und eine die Fehlervorwarnmeldung abbildende zweite Art der Anzeige ansteuern, wenn die genannten Anzeigeverarbeitungsmittel das genannte zweite Anzeigesignal (IS2) liefern.

4. Einrichtung nach irgendeinem der Ansprüche 1 bis 3, **dadurch gekennzeichnet, dass** das erste Anzeigesignal (IS1) und das zweite Anzeigesignal (IS2) den gleichen Leuchtmelder (23, 90, 103) und/oder das gleiche Relais (24) beaufschlagen.

5. Einrichtung nach irgendeinem der Ansprüche 1 bis 4, **dadurch gekennzeichnet, dass** die genannten Anzeigemittel mindestens einen bistabilen Leuchtmelder (103) umfassen.

6. Einrichtung nach irgendeinem der Ansprüche 1 bis 4, **dadurch gekennzeichnet, dass** die genannten Anzeigemittel mindestens eine bistabile Flüssigkristallanzeige (103) umfassen.

7. Einrichtung nach irgendeinem der Ansprüche 1 bis 6, **dadurch gekennzeichnet, dass** sie einen ersten Teil (78) mit den in einem Modul angeordneten genannten Verarbeitungsmitteln, welches Modul auf einem schienenförmigen Träger befestigt werden kann, sowie einen, mindestens die genannten Strommessmittel (30) umfassenden und an den ersten Teil angeschlossenen zweiten Teil umfasst.

8. Differenzstrom-Schutzsystem mit einem elektrischen Schaltgerät (71, 77) und darin angeordneten Hauptkontakten (1), die bei Auftreten eines elektrischen Fehlers abgeschaltet werden können, **dadurch gekennzeichnet, dass** es eine Einrichtung zur Anzeige eines elektrischen Fehlers (72, 78, 79) nach einem der Ansprüche 1 bis 7 mit einem seitlich an das genannte elektrische Schaltgerät angebauten ersten Teil (78) sowie einem gegenüber von Ausgangsklemmen (80) des genannten elektrischen Schaltgeräts angeordneten zweiten Teil (79) umfasst, an dem die genannten Strommessmittel (10) befestigt sind.

9. Differenzstrom-Schutzsystem nach Anspruch 8, **dadurch gekennzeichnet, dass** der genannte Spannungsnachweis-Prüfeingang (30) auf der Abgangsseite des genannten elektrischen Schaltgeräts (71, 77) angeschlossen ist.

10. Verteiler-Schaltanlage mit einem Einspeisesystem (76) und mehreren Verteilerabgängen (74, 94), **dadurch gekennzeichnet, dass** mindestens ein Abgang eine Einrichtung zur Anzeige von elektrischen Fehlern (70, 93) nach einem der Ansprüche 1 bis 7 umfasst.

11. Verteiler-Schaltanlage nach Anspruch 10, **dadurch gekennzeichnet, dass** sie mindestens eine Differenzstrom-Schutzeinrichtung (92) umfasst, die auf der Einspeiseseite mindestens einer Einrichtung zur Anzeige von elektrischen Fehlern (93) angeschlossen ist.

12. Verfahren zur Anzeige elektrischer Fehler, **dadurch gekennzeichnet, dass** es
- die Messung (54) des Differenz- oder Nullstroms,
- den Vergleich (55) des genannten Fehlerstroms mit einem ersten Detektionsschwellwert zur Erkennung einer Schwellwertüberschreitung,
- die Detektion (56, 59) der Überschreitung des genannten ersten Schwellwerts während einer bestimmten Zeitdauer (T),
- die Detektion (57) des Spannungsverlustes an einem Spannungsnachweis-Prüfeingang sowie
- die Lokalisierungsanzeige (58) eines elektrischen Fehlers umfasst, wenn die Überschreitung (55) des genannten ersten Schwellwerts und der Spannungsverlust (57) durch die Spannungsnachweis-Detektionsmittel erkannt werden.

13. Anzeigeverfahren nach Anspruch 10, **dadurch gekennzeichnet, dass** es die Vorwarnanzeige (60, 61) eines elektrischen Fehlers bei Überschreitung des genannten ersten Schwellwerts während einer festgelegten Zeitdauer (T) umfasst.

14. Anzeigeverfahren nach einem der Ansprüche 10 oder 11, **dadurch gekennzeichnet, dass** es die Speicherung (58) der Fehlerlokalisierungsanzeige und die Quittierung (53) der Fehlerlokalisierungsanzeige umfasst.
